# EUROPEAN PATENT SPECIFICATION

(11) **EP 0 678 945 B1**
(45) Date of publication and mention of the grant of the patent: **08.07.1998**
(21) Application number: 95105817.1
(22) Date of filing: 19.04.1995
(51) Int. Cl.: H01S 3/19, H01L 33/00

(54) **Gallium nitride group compound semiconductor laser diode and method of manufacturing the same**
Galliumnitrid-Diodenlaser und Verfahren zu seiner Herstellung
Laser à diode à la nitrure de gallium et methode de sa fabrication

(30) Priority: 20.04.1994 JP 106055/94; 20.04.1994 JP 106056/94
(43) Date of publication of application: 25.10.1995
(73) Proprietor: TOYODA GOSEI CO., LTD., Nishikasugai-gun Aichi-ken (JP); RESEARCH DEVELOPMENT CORPORATION OF JAPAN, Kawaguchii, Saitama 332 (JP); Akasaki, Isamu, Nagoya-shi, Aichi-ken (JP); Amano, Hiroshi, Nagoya-shi, Aichi-ken (JP)
(72) Inventor: Yamazaki, Shiro, Inazawa-shi, Aichi-ken, 492 (JP); Koide, Norikatsu, Nagoya-shi, Aichi-ken, 463 (JP); Manabe, Katsuhide, Ichinomiya-shi, Aichi-ken, 491 (JP); Akasaki, Isamu, Nagoya-shi, Aichi-ken (JP); Amano, Hiroshi, Nagoya-shi, Aichi-ken (JP)
(74) Representative: Tiedtke, Harro, Dipl.-Ing.

(56) References cited:
- EP-A- 0 599 224
- US-A- 5 247 533
- JAPANESE JOURNAL OF APPLIED PHYSICS PART 2, vol. 32, no. 7b, 15 July 1993 TOKYO JP, pages L1000-L1002, XP 000487415 H. AMANO ET AL 'Room temperature low threshold surface stimulated emission by optical pumping from AlGaN/GaN double heterostructure'
- OPTOELECTRONICS DEVICES AND TECHNOLOGIES, vol. 7, no. 1, 1 June 1992 pages 49-56, XP 000294314 ISAMU AKASAKI ET AL 'PERSPECTIVE OF THE UV/BLUE LIGHT EMITTING DEVICES BASED ON GAN AND RELATED COMPOUNDS'
- JAPANESE JOURNAL OF APPLIED PHYSICS PART 2, vol. 31, no. 2b, 15 February 1992 TOKYO JP, pages L139-L142, S. NAKAMURA ET AL 'Thermal annealing effects on p-type Mg-doped GaN Films'
- PATENT ABSTRACTS OF JAPAN vol. 018 no. 673 (E-1647) ,19 December 1994 & JP-A-06 268259 (NICHIA CHEM IND LTD) 22 September 1994,

## Description

The present invention relates to a semiconductor laser diode (laser diode hereinafter) that emits visible short wave rays in the blue to violet and also in the ultraviolet region. Especially, the invention relates to a laser diode which requires less threshold current for oscillation and a method for fabricating such a semiconductor laser diode.

### Description of the Prior Art

A conventional laser diode disclosed in the United States Patent of 5,247,533 is constituted by a gallium nitride group compound semiconductor satisfying the formula (AlₓGa₁₋ₓ)_{y}In_{1-y}N inclusive of 0 ≦ x ≦ 1 and 0 ≦ y ≦ 1, and its active layer is not doped with any impurities. Consequently, the laser diode has a problem of high threshold current for oscillation.

In addition, EP-A-0 599 224, which represents prior art under Art. 54(4) EPC, discloses a light emitting gallium nitride-based compound semiconductor device, in which extrinsic luminescence, i.e. luminescence via impurities, is utilized.

Moreover, the Jap. J. Appl. Phys. 32(1993)7b, Part 2, pp. L1000 to L1002 discloses an experiment measuring the threshold power of surface-stimulated emission by optical pumping from a double-heterostructure (DH), in which the active GaN layer is slightly Si-doped.

It is an object of the present invention to provide a compound semiconductor laser diode having a reduced threshold current for oscillation, as well as a method for fabricating such a diode.

According to the present invention, the above objects are achieved by a compound semiconductor laser diode having a double hetero-junction structure with said double hetero-junction structure sandwiching an active layer by an n-type layer and a p-type layer respectively having wider band gaps than said active layer, said compound semiconductor laser diode respectively satisfying the formula (AlₓGa₁₋ₓ)_{y}In_{1-y}N, including 0 ≤ x ≤ 1 and 0 ≤ y ≤ 1, and electrodes for applying a current to the double hetero-junction structure, wherein said active layer is a p-type conductive layer doped with magnesium (Mg) such that the threshold current of the laser diode is reduced in comparison with the same laser diode whose active layer is not doped with any impurities and whereby laser light is radiated by recombination of electrons and holes between conduction band and valence band.

Moreover, the above objects are achieved by a method for fabricating the compound semiconductor laser diode as defined above, wherein said p-type conductive active layer is obtained by one of electron irradiation, laser irradiation, heat treatment, and any combinations among the electron irradiation, laser irradiation, and the heat treatment.

In addition, the above objects are achieved by a method for fabricating the compound semiconductor laser diode as defined above, wherein said p-type conductive active layer is obtained by heat treatment in the atmosphere of nitrogen (N₂) gases under plasma state.

Furthermore, the above objects are achieved by a compound semiconductor laser diode having a double hetero-junction structure with said double hetero-junction sandwiching an active layer by an n-type layer and a p-type layer respectively having wider band gaps than said active layer, said compound semiconductor laser diode respectively satisfying the formula (AlₓGa₁₋ₓ)_{y}In_{1-y}N, including 0 ≤ x ≤1 and 0 ≤ y ≤ 1, and electrodes for applying a current to the double hetero-junction structure, wherein said active layer is an n-type conductive doped with silicon (Si) such that the threshold current of the laser diode is reduced in comparison with the same laser diode whose active layer is not doped with any impurities, provided that if x = 0 for the active layer then y ≠ 1 for the n-type and the p-type sandwiching layers.

When the active layer is constituted by Mg-doped GaN compound of p-type satisfying the formula (AlₓGa₁₋ₓ)_{y}In_{1-y}N inclusive of 0 ≦ x ≦ 1 and 0 ≦ y ≦ 1, emission efficiency between bands is enhanced resulting in lowering threshold current for oscillation.

Further, when the active layer is constituted by Si-doped GaN compound of n-type satisfying the formula (AlₓGa₁₋ₓ)_{y}In_{1-y}N inclusive of 0 ≦ x ≦ 1 and 0 ≦ y ≦ 1, emission efficiency of the active layer is improved resulting in lowering threshold current for oscillation.

Other objects, features, and characteristics of the present invention will become apparent upon consideration of the following description in the appended claims with reference to the accompanying drawings, all of which form a part of the specification, and wherein referenced numerals designate corresponding parts in the various figures.

### BRIEF DESCRIPTION OF THE DRAWING

In the accompanying drawings:
FIG. 1 is a diagram showing the structure of the laser diode embodied in Example 1; and
FIG. 2 is a diagram showing the structure of the laser diode embodied in Example 2.

### DETAILED DESCRIPTION OF THE PREFERRED EMBODIMENT

The invention will be more fully understood by reference to the following examples.

### Example 1

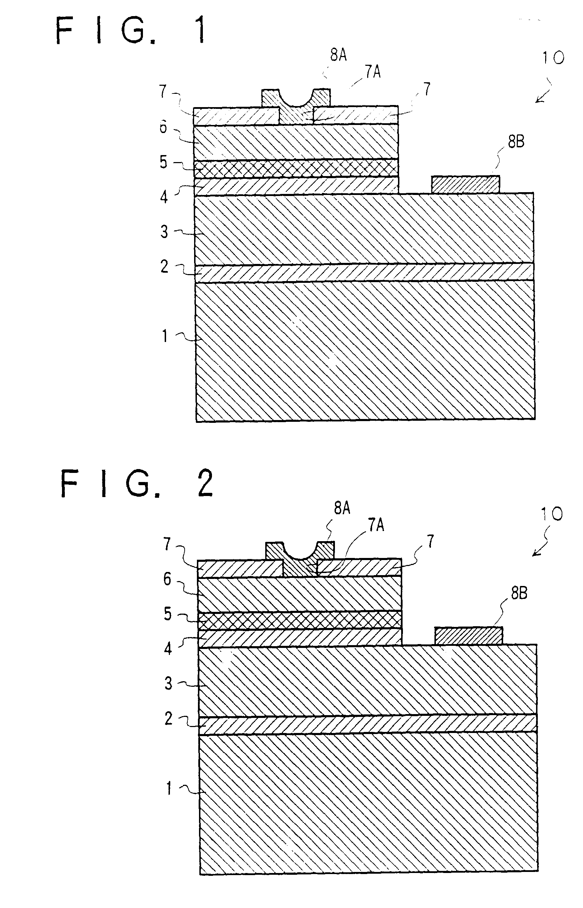

FIG. 1 is a sectional view of a laser diode 10 with a sapphire substrate 1 embodied in Example 1.

The sapphire substrate 1 of single crystalline, whose main surface "c" (0001) was cleaned by an organic washing solvent and heat treatment, was placed on a susceptor in a reaction chamber for the MOVPE treatment. After the chamber is evacuated, the sapphire substrate 1 was etched at 1200 °C by a vapor of H₂ fed into the chamber under normal pressure. As a result, hydrocarbon group gases previously attached to the surface of the sapphire substrate 1 were removed to some extent.

About a 50 nm thick aluminum nitride (AlN) buffer layer 2 was epitaxially formed on the sapphire substrate 1 under conditions of lowering the temperature of the sapphire substrate 1 to 400 °C, keeping the temperature constant, and supplying trimethyl aluminum (Al(CH₃)₃) (TMA hereinafter) and ammonia (NH₃).

On the buffer layer 2, silicon (Si) doped GaN n⁺-layer 3 of high carrier concentration was formed under conditions of raising the temperature of the sapphire substrate 1 to 1150 °C, stopping supplying only TMA, and additionally supplying trimethyl gallium (Ga(CH₃)₃) (TMG hereinafter), and silane (SiH₄).

The wafer was taken out from the chamber so as to cover a portion of the GaN layer 3 as a mask with silicon oxide (SiO₂), and returned into the chamber. The chamber was evacuated again and supplied with hydrogen (H₂) and NH₃ raising the temperature of the sapphire substrate 1 to 1150 °C.

Then, about a 0.5 µm thick undoped Al_{0.1}Ga_{0.9}N n-layer 4 was formed on the portion of the n⁺-layer 3 which was not covered with SiO₂ by supplying TMA and TMG.

About a 0.4 µm thick magnesium (Mg) doped GaN active layer 5 was formed on the n-layer 4 by supplying TMG and biscyclopentadienyl magnesium (Mg(CH₅H₅)₂) (CP₂Mg hereinafter).

About 0.5 µm thick Mg-doped Al_{0.1}Ga_{0.9}N p-layer 6 was formed on the active layer 5 by supplying TMA, TMG, and CP₂Mg.

Then, the SiO₂ layer covering the portion of the n⁺-layer 3 as a mask was removed by a hydrofluoric acid group etching liquid.

After a SiO₂ layer 7 was formed on the p-layer 6, a strip-like window 7A of 1 mm by 50 µm in dimensions was formed. Then, the wafer was transferred into a vacuum chamber, and electron rays were irradiated into the Mg-doped p-layer 6 and the Mg-doped active layer 5. This irradiation changed those layers 5 and 6 into p-type conductive layers.

Typical irradiation conditions are:
15 KV for the electron accelerating voltage;
120 µA for the emission current;
60 µmφ for the electron spot diameter;and
297 K for the sample temperature.

Subsequently, a metal electrode 8A was formed in the strip-like window 7A, and a metal electrode 8B on the GaN n⁺-layer 3.

The obtained laser diode 10 was found to require 90 % lesser threshold current for oscillation than a conventional laser diode whose GaN active layer was not doped with any impurities.

### Example 2

FIG. 2 is a sectional view exhibiting a structure of the semiconductor laser diode with a sapphire substrate in Example 2. A difference between Examples 1 and 2 resides in the active layer 5. In example 2, the active layer 5 is doped with silicon (Si), although the active layer 5 in Example 1 is doped with magnesium (Mg) and is irradiated with electron beams for p-type conduction. The manufacturing processes up to the AlGaN n-layer 4 were the same as those described in Example 1.

On the n-layer 4, about a 0.4 µm thick Si-doped GaN active layer 5 was formed by supplying TMG and SiH₄.

Subsequently, Al_{0.1}Ga_{0.9}N p-layer 6 and metal electrodes 8A and 8B were formed by the same processes that were described in Example 1. The electron irradiation was carried out only onto the Mg-doped p-layer 6 at the same conditions as those which were described in Example 1.

The obtained laser diode 10 was found to require 90 % lesser threshold current for oscillation than a conventional laser diode whose GaN emission layer was not doped with any impurities.

Although sapphire was employed as the substrate in Examples 1 and 2, a silicon substrate, a 6H-SiC substrate, or a GaN substrate can be used, alternatively.

Further, one of electron irradiation, laser irradiation, heat treatment and any combinations among the electron irradiation, the laser irradiation, and the heat treatment can be used alternatively, although electron irradiation was employed for the p-type conductive layers 5 and 6 in Example 1 and for the p-layer 6 in Example 2.

Further, the p-type conductive layers were alternatively obtained by heat treatment in the atmosphere of nitrogen (N₂) gases under plasma state as described in the following processes.

The reaction chamber was evacuated, and then, N₂ gases were introduced there keeping the pressure of the chamber 1,33·10⁴ Pa (100 Torr) or less. After plasma discharge was carried out in the chamber at electric power of 10 to 100 W, heat treatment was carried out onto the substrate 2 for 5 to 60 min. keeping its temperature 500 to 900 °C. This discharge can be carried out with any one of high-frequency wave, microwave, direct current, and so on, alternatively. The substrate 2 was placed either in the state of plasma discharge that both of N radical species and ionized species existed or in the state of afterglow that only N radical species existed. The optimum conditions for the p-type conductive layers with fine crystallinity were 750 °C temperature of the sapphire substrate 1 and 40 W of electric power.

While the invention has been described in connection with what are presently considered to be the most practical and preferred embodiments, it is to be understood that the invention is not to be limited to the disclosed embodiments, but on the contrary, is intended to cover various modifications and equivalent arrangements included within the scope of the appended claims.

## Claims

1. A compound semiconductor laser diode (10) having: a double hetero-junction structure with said double hetero-junction structure sandwiching an active layer (5) by an n-type layer (4) and a p-type layer (6) respectively having wider band gaps than said active layer (5), said compound semiconductor laser diode respectively satisfying the formula (AlₓGa₁₋ₓ)_{y}In_{1-y}N, including 0 ≤ x ≤ 1 and 0 ≤ y ≤ 1, and electrodes for applying a current to the double hetero-junction structure,
**characterized in that**
said active layer (5) is a p-type conductive layer doped with magnesium such that the threshold current of the laser diode is reduced in comparison with the same laser diode whose active layer is not doped with any impurities and whereby laser light is radiated by recombination of electrons and holes between conduction band and valence band.

2. A method for fabricating the compound semiconductor laser diode (10) of claim 1, wherein said p-type conductive active layer (5) is obtained by one of electron irradiation, laser irradiation, heat treatment, and any combinations among the electron irradiation, laser irradiation, and the heat treatment.

3. A method for fabricating the compound semiconductor laser diode (10) of claim 1, wherein said p-type conductive active layer (5) is obtained by heat treatment in the atmosphere of nitrogen gases under plasma state.

4. A compound semiconductor laser diode (10) having: a double hetero-junction structure with said double hetero-junction sandwiching an active layer (5) by an n-type layer (4) and a p-type layer (6) respectively having wider band gaps than said active layer (5), said compound semiconductor laser diode respectively satisfying the formula (AlₓGa₁₋ₓ)_{y}In_{1-y}N, including 0 ≤ x ≤ 1 and 0 ≤ y ≤ 1, and electrodes for applying a current to the double hetero-junction structure, wherein
said active layer (5) is an n-type conductive doped with silicon such that the threshold current of the laser diode is reduced in comparison with the same laser diode whose active layer is not doped with any impurities,
subject to the proviso that if x = 0 for the active layer then y ≠ 1 for the n-type and the p-type sandwiching layers.

## Patentansprüche

1. Halbleiterlaserdiode (10) mit:
einer Doppel-Heteroübergangsstruktur, wobei die Doppel-Heteroübergangsstruktur eine aktive Schicht (5) durch eine n-Schicht (4) und eine p-Schicht (6) mit jeweils größeren Bandlücken als die aktive Schicht (5) sandwichartig einschließt, die Halbleiterverbindung der Laserdiode jeweils die Formel (AlₓGa₁₋ₓ)_{y}In_{1-y}N einschließlich 0 ≤ x ≤ 1 und 0 ≤ y ≤ 1 erfüllt, und
Elektroden zum Anlegen eines Stroms an die Doppel-Heteroübergangsstruktur,
**dadurch gekennzeichnet, daß**
die aktive Schicht (5) eine p-leitende Schicht ist, die derart mit Magnesium dotiert ist, daß der Schwellenstrom der Laserdiode im Vergleich zu der gleichen Laserdiode mit einer aktiven Schicht ohne jegliche Dotierung mit Verunreinigungen verringern ist, und Laserlicht durch die Rekombination von Elektronen und Löchern zwischen dem Leitungsband und Valenzband abgestrahlt wird.

2. Verfahren zur Herstellung einer Halbleiterlaserdiode 10) gemäß Anspruch 1, wobei die p-leitende aktive Schicht (5) entweder durch Elektronenbestrahlung, Laserbestrahlung, Hitzebehandlung oder irgendwelchen Kombinationen von Elektronenbestrahlung, Laserbestrahlung und Hitzehehandlung erhalten wird.

3. Verfahren zur Herstellung einer Halbleiterlaserdiode (10) gemäß Anspruch 1, wobei die p-leitende aktive Schicht (5) durch eine Hitzebehandlung in einer Stickstoffatmosphäre unter Plasmabedingungen erhalten wird.

4. Halbleiterlaserdiode (10) mit:
einer Doppel-Heteroübergangsstruktur, wobei die Doppel-Heteroübergangsstruktur eine aktive Schicht (5) durch eine n-Schicht (4) und eine p-Schicht (6) mit jeweils größeren Bandlücken als die aktive Schicht (5) sandwichartig einschließt, die Halbleiterverbindung der Laserdiode jeweils die Formel (AlₓGa₁₋ₓ)_{y}In_{1-y}N einschließlich 0 ≤ x ≤ 1 und 0 ≤ y ≤ 1 erfüllt, und
Elektroden zum Anlegen eines Stroms an die Doppel-Heteroübergangsstruktur, wobei
die aktive Schicht (5) eine n-leitende Schicht ist, die derart mit Silicium dotiert ist, daß der Schwellenstrom der Laserdiode im Vergleich zu der gleichen Laserdiode mit einer aktiven Schicht ohne jegliche Dotierung mit Verunreinigungen verringert ist,
mit der Maßgabe, daß für die sandwichartig einschließenden n- und p-Schichten y ≠ 1 ist, wenn für die aktive Schicht x = 0 ist.

## Revendications

1. Diode laser à semiconducteur de type composé (10) comprenant : une structure à double hétéro-jonction, ladite structure à double hétéro-jonction prenant en sandwich une couche active (5) entre une couche de type n (4) et une couche de type p (6) ayant respectivement des largeurs de bande interdite plus larges que celle de ladite couche active (5), ladite diode laser à semiconducteur de type composé répondant respectivement à la formule (AlₓGa₁₋ₓ)_{y}In_{1-y}N, dans laquelle 0 ≤ x ≤ 1, et 0 ≤ y ≤ 1, et des électrodes pour appliquer un courant à la structure à double hétéro-jonction,
caractérisée en ce que :
ladite couche active (5) est une couche conductrice de type p dopée au magnésium, de telle sorte que le courant de seuil de la diode laser soit réduit par rapport à celui de la même diode laser dont la couche active n'est dopée par aucune impureté, et grâce à quoi une lumière laser est rayonnée par recombinaison d'électrons et de trous entre la bande de conduction et la bande de valence.

2. Procédé pour fabriquer la diode laser à semiconducteur de type composé (10) selon la revendication 1, dans lequel ladite couche active conductrice de type p dopée (5) est obtenue par l'un parmi l'irradiation d'électrons, l'irradiation de laser, le traitement thermique et toutes combinaisons de l'irradiation d'électrons, de l'irradiation de laser et du traitement thermique.

3. Procédé pour fabriquer la diode laser à semiconducteur de type composé (10) selon la revendication 1, dans lequel ladite couche active conductrice de type p (5) est obtenue par traitement thermique dans l'atmosphère de gaz azote à l'état de plasma.

4. Diode laser à semiconducteur de type composé (10) comprenant : une structure à double hétéro-jonction, ladite double hétéro-jonction prenant en sandwich une couche active (5) entre une couche de type n (4) et une couche de type p (6) ayant respectivement des largeurs de bande interdite plus larges que celle de ladite couche active (5), ladite diode laser à semiconducteur de type composé répondant respectivement à la formule (AlₓGa₁₋ₓ)_{y}In_{1-y}N, dans laquelle 0 ≤ x ≤ 1, et 0 ≤ y ≤ 1, et des électrodes pour appliquer un courant à la structure à double hétéro-jonction, dans laquelle :
ladite couche active (5) est une couche conductrice de type n dopée au silicium, de telle sorte que le courant de seuil de la diode laser soit réduit par rapport à celui de la même diode laser dont la couche active n'est dopée par aucune impureté, pourvu que si x = 0 pour la couche active, alors, y ≠ 1 pour les couches de prise en sandwich du type n et du type p.
